(19) Europäisches Patentamt / European Patent Office / Office européen des brevets

(11) **EP 4 550 972 A1**

(12) **EUROPEAN PATENT APPLICATION**

(43) Date of publication:
**07.05.2025 Bulletin 2025/19**

(21) Application number: **24209923.2**

(22) Date of filing: **30.10.2024**

(51) International Patent Classification (IPC):
**H10D 12/01** (2025.01)     **H10D 12/00** (2025.01)
**H10D 64/27** (2025.01)

(52) Cooperative Patent Classification (CPC):
**H10D 12/038; H10D 12/417; H10D 12/481;
H10D 64/232; H10D 64/516;** H10D 12/418;
H10D 62/106; H10D 62/127; H10D 64/518

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.10.2023   CN 202311422812**

(71) Applicants:
• **Nexperia B.V.**
  **6534 AB Nijmegen (NL)**
• **Nexperia Technology (Shanghai) Ltd.**
  **Shanghai 200025 (CN)**

(72) Inventors:
• **Zhang, Ken**
  **Shanghai (CN)**
• **Zhu, Chunlin**
  **Shanghai (CN)**
• **Jiang, Ke**
  **Shanghai (CN)**
• **Wu, Zeyu**
  **Shanghai (CN)**
• **Zuo, Huiling**
  **Shanghai (CN)**

(74) Representative: **Pjanovic, Ilija**
  **Nexperia B.V.**
  **Legal & IP**
  **Jonkerbosplein 52**
  **6534 AB Nijmegen (NL)**

(54) **SEMICONDUCTOR DEVICE AND METHOD FOR MANUFACTURING SAME**

(57)     The disclosure provides a semiconductor device and a method for manufacturing the same. The semiconductor device includes a semiconductor layer. The semiconductor layer has a first surface and a second surface opposite to each other. The semiconductor layer includes: a source region and gate regions. The source region includes an N-type source region, a first P-type body layer and a carrier storage layer. Each gate region includes a gate oxide layer and polysilicon. A side wall and a bottom of the polysilicon are surrounded by the gate oxide layer. The source region is arranged between the adjacent two gate regions, and contacts the gate oxide layers of the adjacent two gate regions. In the gate region, with respect to the first surface, the gate oxide layer extends from a depth where a top of the N-type source region is located to a first depth. The bottom of the polysilicon is away from the first surface and is located at a second depth. A part of the gate oxide layer from a top of the gate oxide layer to the third depth has a constant thickness in a transverse direction. A part of the gate oxide layer from the third depth to the second depth has a gradually increasing thickness in the transverse direction. The third depth is within a range of a depth where the first P-type body layer is located.

**Description**

**Technical Field**

The disclosure belongs to the field of semiconductor devices, and particularly relates to a semiconductor device having a source region and a plurality of gate regions and a method for manufacturing the same.

**Background**

An insulated gate bipolar transistor (IGBT) is a composite fully-controlled voltage-driven power semiconductor device including a bipolar junction transistor (BJT) and an insulated gate field-effect transistor (MOSFET). The threshold voltage $V_{th}$ of an IGBT semiconductor device is influenced by the parameters such as the input capacitance $C_{iss}$, the reverse transfer capacitance ($C_{rss}$) and the doping concentration of the gate oxide layer. The reverse transfer capacitance $C_{rss}$ is influenced by the gate-collector capacitance $C_{gc}$ (e.g., $C_{rss}=C_{GC}$), and the input capacitance $C_{iss}$ is influenced by both the gate-emitter capacitance $C_{ge}$ and the gate-collector capacitance $C_{gc}$ (e.g., $C_{iss}=C_{GE}+C_{GC}$).

In the IGBT semiconductor devices in the prior art, especially in the IGBT semiconductor devices having a trench structure, in order to stabilize the threshold voltage of the semiconductor device, a typical method is to reduce the gate-collector capacitance $C_{gc}$ by increasing the thickness of the gate oxide layer at the bottom of the trench so as to reduce the reverse transfer capacitance $C_{rss}$. For example, US9000514B2 discloses a design in the prior art. In this design, as shown in FIG. 1, the change in thickness P23 of the gate oxide layer occurs in a region below the bottom of the P-type body layer P12 of the semiconductor device. However, this design cannot reduce the gate-collector capacitance $C_{gc}$ and the gate-emitter capacitance $C_{ge}$ at the same time, thus, cannot effectively adjust the input capacitance $C_{iss}$ and cannot effectively stabilize the threshold voltage of the semiconductor device.

Therefore, it is necessary to provide an improved semiconductor device that can solve the above technical problems.

**Summary**

In order to solve the above technical problems in the prior art, the disclosure provides a semiconductor device and a method for manufacturing the same.

The semiconductor device provided by the disclosure includes a semiconductor layer. The semiconductor layer has a first surface and a second surface opposite to each other. The semiconductor layer includes: a source region, including an N-type source region, a first P-type body layer and a carrier storage layer stacked along a first direction pointing from the first surface to the second surface; and a plurality of gate regions, arranged along a second direction perpendicular to the first direction, each gate region including a gate oxide layer and polysilicon, and a side wall and a bottom of the polysilicon being surrounded by the gate oxide layer. The source region is arranged between the adjacent two of the plurality of gate regions in the second direction, and contacts the gate oxide layers of the adjacent two gate regions along the second direction. In each gate region, with respect to the first surface, the gate oxide layer extends along the first direction from a depth where a top of the N-type source region is located to a first depth h1. The bottom of the polysilicon is away from the first surface and is located at a second depth h2 with respect to the first surface. A part of the gate oxide layer from a top of the gate oxide layer to a third depth h3 has a constant thickness in the second direction, where h3<h2<h1. A part of the gate oxide layer from the third depth h3 to the second depth h2 has a gradually increasing thickness in the second direction. The third depth h3 is within a range of a depth where the first P-type body layer is located.

In some embodiments, for each gate region, a thickness of the gate oxide layer in the second direction at any depth hx within a depth range from the third depth h3 to the second depth h2 is a function of a P-type well concentration $N_a$ of the first P-type body layer at the depth hx.

In some embodiments, for each gate region, the thickness $T_{ox}$ of the gate oxide layer in the second direction at any depth hx within the depth range from the third depth h3 to the second depth h2 and the P-type well concentration $N_a$ of the first P-type body layer at the depth hx satisfies the following formula:

$$T_{ox} \leq \frac{V_{th\_1}\varepsilon_0\varepsilon_{ox}}{\sqrt{4\varepsilon_0\varepsilon_s KT N_a ln\left(\frac{N_a}{N_i}\right)}}$$

where K is a Boltzmann constant, T is an absolute temperature, $N_i$ is a concentration of intrinsic carriers of the first P-type body layer at the depth hx, $\varepsilon_0$ is a vacuum permittivity, $\varepsilon_s$ is a relative permittivity of silicon, $\varepsilon_{ox}$ is a relative permittivity of the gate oxide layer, and $V_{th\_1}$ is a preset constant.

In some embodiments, along the first direction, the second depth h2 is within a range of a depth where the carrier storage layer is located; or along the first direction, the second depth h2 exceeds the range of the depth where the carrier storage layer is located.

In some embodiments, for each gate region, in the second direction, the part of the gate oxide layer from the third depth h3 to the second depth h2 has the gradually increasing thickness on both sides along the second direction.

In some embodiments, for each gate region, in the second direction, the part of the gate oxide layer from the third depth h3 to the second depth h2 has the gradually increasing thickness only on a side close to the source region.

In some embodiments, for each gate region, in the second direction, a side of a part of the gate oxide layer from the first surface to the third depth h3 away from the source region is exposed to an outside of the semiconductor device along the second direction.

In some embodiments, the semiconductor layer further includes a second P-type body layer. The second P-type body layer extends along the first direction from the depth where the top of the N-type source region is located, and the second P-type body layer contacts the gate oxide layer of the adjacent gate region along the second direction.

In some embodiments, gate regions adjacent to the N-type source region in the plurality of gate regions are active gate regions, and gate regions adjacent to the second P-type body layer but not adjacent to the N-type source region, in the plurality of gate regions are passive gate regions. The passive gate regions and the active gate regions are arranged in a preset number proportion in the semiconductor device.

In some embodiments, at least one gate region in the plurality of gate regions includes one gate oxide layer and two pieces of polysilicon. The two pieces of polysilicon are arranged along the second direction in the gate oxide layer.

In some embodiments, the semiconductor device is a trench IGBT unit.

In some embodiments, the semiconductor layer further includes an inter layer dielectric (ILD) extending along the first direction from the first surface. The inter layer dielectric contacts a top surface of the N+ source region, and a top surface of the gate oxide layer and a top surface of the polysilicon in each gate region along the first direction.

In some embodiments, the semiconductor device further includes: a top surface metal layer, including a first part arranged on the inter layer dielectric and a second part extending from a bottom surface of the first part along the first direction through the inter layer dielectric and the N+ source region to contact the first P-type body layer; and a bottom surface metal layer, arranged to cover the second surface of the semiconductor layer along a direction opposite to the first direction.

The method for manufacturing the semiconductor device provided by the disclosure includes: providing a semiconductor substrate layer; forming a plurality of trenches in the semiconductor substrate layer by etching such that each trench is configured to extend from a side of a first surface of the semiconductor substrate layer along a first direction to a position corresponding to a first depth h1; filling each trench with an oxide; forming the gate oxide layer in each trench; depositing polysilicon in the etched oxide in each trench; and etching the polysilicon to form a plurality of gate regions.

In some embodiments, the forming the gate oxide layer in each trench includes: performing isotropic dry etching on the oxide to a position corresponding to the third depth h3, and performing anisotropic dry etching on the oxide from the third depth h3 to a position corresponding to the second depth h2.

In some embodiments, the forming the gate oxide layer in each trench further includes: filling each trench with an additional oxide to form a side wall of the gate oxide layer after the oxide is etched from the third depth h3 to the position corresponding to the second depth h2.

In some embodiments, the method further includes: forming the source region in the semiconductor substrate layer.

In some embodiments, the forming the source region in the semiconductor substrate layer includes: sequentially forming a first P-type body layer and a carrier storage layer by ion implantation and drive-in from the side of the first surface of the semiconductor substrate layer; and forming an N-type source region in the first P-type body layer along a direction opposite to the first direction.

In some embodiments, the method further includes: forming an inter layer dielectric covering the plurality of gate regions and the source region by depositing an oxide, a top surface of the inter layer dielectric being the first surface of the semiconductor layer.

In some embodiments, the method further includes: forming a contact hole at a position corresponding to the source region, the contact hole extending from the top surface of the inter layer dielectric along the first direction through the inter layer dielectric and the N-type source region to the first P-type body layer; forming a top surface metal layer on the top surface of the inter layer dielectric and in the contact hole; and forming a bottom surface metal layer on a side of a second surface of the semiconductor substrate layer.

According to the semiconductor device and the method for manufacturing the same of the disclosure, by setting the start point of the change in thickness of the gate oxide layer in the region overlapping with the P-type body layer in the longitudinal depth direction and making the thickness of the gate oxide layer gradually increase along the depth direction, the gate-collector capacitance $C_{gc}$ and the gate-emitter capacitance $C_{ge}$ of the semiconductor device can be adjusted at the same time, thereby stabilizing the threshold voltage of the semiconductor device and obtaining better didt (current change rate) and dvdt (voltage change rate) control abilities at switching transients.

**Brief Description of Figures**

FIG. 1 shows a design of a semiconductor device in the prior art;

FIG. 2 shows a schematic structural view of a semiconductor device according to a first embodiment of the disclosure;

FIG. 3 shows a schematic structural view of a semiconductor device according to a second embodiment of the disclosure;

FIG. 4 shows a schematic structural view of a semiconductor device according to a third embodiment of the disclosure;

FIG. 5 shows a schematic structural view of a semiconductor device according to a fourth embodiment of the disclosure;

FIG. 6 shows a schematic structural view of a semiconductor device according to a fifth embodiment of the disclosure;

FIG. 7 shows an example of a curve diagram of a relationship between a thickness of a gate oxide layer and a P-type well concentration of a P-type body layer of the semiconductor device according to an embodiment of the disclosure;

FIG. 8 shows a flowchart of a method for manufacturing a semiconductor device according to a sixth embodiment of the disclosure;

FIG. 9 shows a schematic structural view of the semiconductor device after a trench is formed according to the sixth embodiment of the disclosure;

FIG. 10 shows a schematic structural view of the semiconductor device after the trench is filled with an oxide according to the sixth embodiment of the disclosure;

FIG. 11 shows a schematic structural view of the semiconductor device after a first part of the gate oxide layer is formed in the trench according to the sixth embodiment of the disclosure;

FIG. 12 shows a schematic structural view of the semiconductor device after a second part of the gate oxide layer is formed in the trench according to the sixth embodiment of the disclosure;

FIG. 13 shows a schematic structural view of the semiconductor device after a side wall of the gate oxide layer is formed in the trench according to the sixth embodiment of the disclosure;

FIG. 14 shows a schematic structural view of the semiconductor device after polysilicon is deposited in the etched oxide in the trench according to the sixth embodiment of the disclosure;

FIG. 15 shows a schematic structural view of the semiconductor device after the polysilicon is etched according to the sixth embodiment of the disclosure;

FIG. 16 shows a schematic structural view of the semiconductor device after a carrier storage layer and a first P-type body layer are sequentially formed by ion implantation and drive-in according to the sixth embodiment of the disclosure;

FIG. 17 shows a schematic structural view of the semiconductor device after an N-type source region is formed according to the sixth embodiment of the disclosure; and

FIG. 18 shows a schematic structural view of the semiconductor device according to the sixth embodiment of the disclosure.

**Detailed Description**

The disclosure will be described below by way of example with reference to the accompanying drawings. The following description discloses or shows various objectives, features and aspects of the disclosure. It can be understood by those skilled in the art that the following discussion is only for describing exemplary embodiments, and is not intended to limit the broader aspects of the disclosure embodied in exemplary constructions. Table 1 is a list of components and corresponding reference numerals in the accompanying drawings, where the same or similar reference numerals denote the same or similar components in the accompanying drawings. Therefore, once a component is defined in one embodiment, further definition and explanation may be omitted in other embodiments.

Table 1

| Reference numeral | Component name |
|---|---|
| 1 | Semiconductor device |
| 10 | Semiconductor layer |
| 110; 210; 310; 410; 510; 610 | Source region |
| 111; 211; 311; 411; 511; 611 | N-type source region |

(continued)

| Reference numeral | Component name |
|---|---|
| P12; 112; 212; 312; 412; 512; 612 | First P-type body layer |
| 113; 213; 313; 413; 513 | Carrier storage layer |
| 114; 214; 314; 414; 514; 614 | Top of N-type source region |
| 120; 220; 320; 420; 520; 620 | Gate region |
| 121; 221; 321; 421; 521; 621 | Gate oxide layer |
| 122; 222; 322; 422; 522; 622 | Polysilicon |
| P23; 123; 223; 323; 423; 523; 623 | Start point of increase in thickness of gate oxide layer |
| 124; 224 | Bottom of polysilicon |
| 131; 231; 431; 631 | Second P-type body layer |
| 132; 232; 332; 432; 532; 632 | Inter layer dielectric |
| 133; 233; 333; 433; 533; 633 | N-type drift layer |
| 134; 234; 334; 434; 534; 634 | Buffer layer |
| 135; 235; 335; 435; 535; 635 | P emitter layer |
| 20 | Top surface metal layer |
| 21 | First part of top surface metal layer |
| 22 | Second part of top surface metal layer |
| 30 | Bottom surface metal layer |
| S1 | First surface |
| S2 | Second surface |
| D1 | First direction |
| D2 | Second direction |
| h1 | First depth |
| h2 | Second depth |
| h3 | Third depth |

In the description of this disclosure, it should be noted that the orientation or position relationship indicated by the terms "top", "bottom", "up", "down", "left", "right", "inside" and "outside" is the orientation or position relationship based on the accompanying drawings, or the orientation or position relationship that products are usually placed in use, and is intended only to facilitate the description of the disclosure and simplicity of the description and not to indicate or imply that the apparatus or element referred to must have a specific orientation or be constructed and operated in a specific orientation, so it cannot be understood as limiting the disclosure. Certainly, when the semiconductor device is installed in a circuit, the position relationship between the components is based on the actual orientation.

In addition, in the description of the disclosure, unless otherwise specified, the expression of the singular form may include the plural concept.

In addition, the terms "first", "second" and the like are only used for descriptive purposes, and should not be understood as indicating or implying relative importance or sequence.

Besides, it should be noted that the features in the embodiments of the disclosure can be arbitrarily combined with each other in case of no conflict.

Semiconductor device

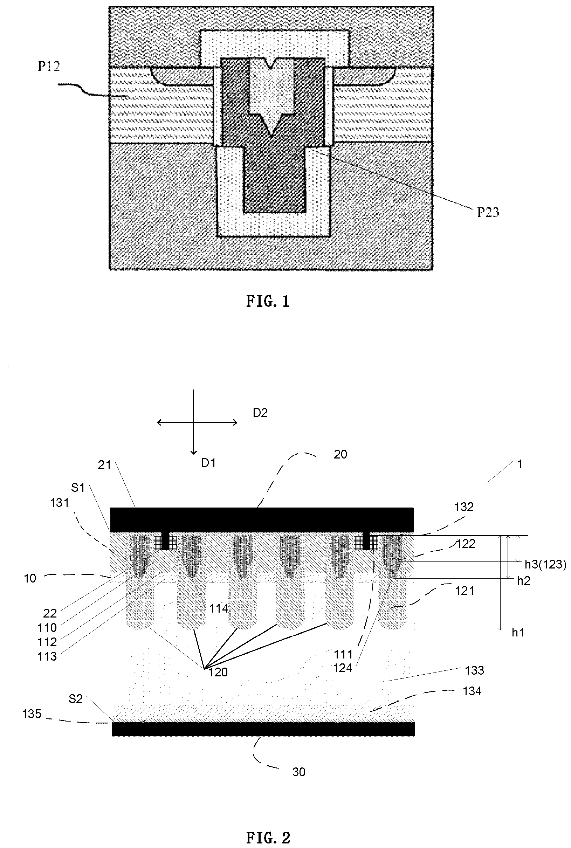

FIG. 2 to FIG. 6 show a semiconductor device 1 according to different embodiments of the disclosure. The semiconductor device 1 includes a semiconductor layer 10. The semiconductor layer 10 has a first surface S1 and a second surface S2 opposite to each other. The semiconductor layer 10 includes a source region (110; 210; 310; 410; 510) and a plurality of gate regions (120; 220; 320; 420; 520).

The source region (110; 210; 310; 410; 510) includes an N-type source region (111; 211; 311; 411; 511), a first P-type body layer (112; 212; 312; 412; 512) and a carrier storage layer (113; 213; 313; 413; 513) stacked along a first direction D1 (i.e., a downward direction in the drawings) pointing from the first surface S1 to the second surface S2. In other words, the N-type source region (111; 211; 311; 411; 511), the first P-type body layer (112; 212; 312; 412; 512) and the carrier storage layer (113; 213; 313; 413; 513) are sequentially stacked from top to bottom along the first direction D1.

The plurality of gate regions (120; 220; 320; 420; 520) are arranged along a second direction D2 (i.e., a transverse direction in the drawings) perpendicular to the first direction D1. Each gate region (120; 220; 320; 420; 520) includes a gate oxide layer (121; 221; 321; 421; 521) and polysilicon (122; 222; 322; 422; 522). A side wall and a bottom (124; 224) of the polysilicon are surrounded by the gate oxide layer (121; 221; 321; 421; 521).

The source region (110; 210; 310; 410; 510) is arranged between the adjacent two of the plurality of gate regions (120; 220; 320; 420; 520) in the second direction D2, and contacts the gate oxide layers (121; 221; 321; 421; 521) of the adjacent two gate regions along the second direction D2. In other words, the source region (110; 210; 310; 410; 510) is arranged between the adjacent two gate regions in the transverse direction.

In each gate region (120; 220; 320; 420; 520), with respect to the first surface S1, the gate oxide layer (121; 221; 321; 421; 521) extends along the first direction D1 from a depth where a top (114; 214; 314; 414; 514) of the N-type source region (111; 211; 311; 411; 511) is located to a first depth h1. The bottom (124; 224) of the polysilicon is away from the first surface S1 and is located at a second depth h2 with respect to the first surface S1. A part of the gate oxide layer (121; 221; 321; 421; 521) from a top of the gate oxide layer to a third depth h3 has a constant thickness in the second direction. Third depth h3<second depth h2<first depth h1. A part of the gate oxide layer (121; 221; 321; 421; 521) from the third depth h3 to the second depth h2 has a gradually increasing thickness in the second direction D2. In other words, in the first direction D1, the top of the gate oxide layer (121; 221; 321; 421; 521) (i.e., the top of the polysilicon), the third depth h3 (i.e., the start point of the increase in thickness of the gate oxide layer (123; 223; 323; 423; 523)), the second depth h2 (i.e., the bottom of the polysilicon) and the first depth h1 (i.e., the bottom of the gate oxide layer) are sequentially arranged from top to bottom. The thickness of the gate oxide layer (121; 221; 321; 421; 521) in the transverse direction gradually increases downward from the third depth h3 (at least to the second depth h2). The third depth h3 is within a range of a depth where the first P-type body layer is located. In other words, the depth of the start point of the increase in thickness of the gate oxide layer is located between the depth where the top of the first P-type body layer (112; 212; 312; 412; 512) (the bottom of the N-type source region) is located and the depth where the bottom of the first P-type body layer (112; 212; 312; 412; 512) (the top of the carrier storage layer) is located. That is, the start point of the increase in thickness of the gate oxide layer overlaps with a transverse projection of the first P-type body layer. In the range of the depth where the first P-type body layer (112; 212; 312; 412; 512) is located, the thickness of the gate oxide layer influences the gate-emitter capacitance $C_{ge}$. Based on this, the gate-emitter capacitance $C_{ge}$ of the semiconductor device of the disclosure is changed by gradually increasing the thickness of the gate oxide layer.

By means of the above design, the semiconductor device of the disclosure has the following advantages: The gate-collector capacitance $C_{gc}$ and the gate-emitter capacitance $C_{ge}$ of the semiconductor device can be adjusted at the same time, so that the reverse transfer capacitance $C_{rss}$ and the input capacitance $C_{iss}$ can be adjusted at the same time, thereby stabilizing the threshold voltage of the semiconductor device and obtaining better didt and dvdt control abilities at switching transients.

According to an embodiment of the disclosure, for each gate region (120; 220; 320; 420; 520), a thickness of the gate oxide layer (121; 221; 321; 421; 521) in the second direction D2 at any depth hx within a depth range from the third depth h3 to the second depth h2 may be a function of a P-type well concentration $N_a$ of the first P-type body layer (112; 212; 312; 412; 512) at the depth hx. In other words, at any depth hx within the depth range from the third depth h3 to the second depth h2, the thickness of the gate oxide layer in the transverse direction depends on the P-type well concentration $N_a$ of the first P-type body layer (112; 212; 312; 412; 512) at the depth hx.

As described above, the thickness of the gate oxide layer influences the gate-emitter capacitance $C_{ge}$ and the gate-collector capacitance $C_{gc}$. By means of the above design, according to the semiconductor device of the disclosure, the thickness of the gate oxide layer among the influencing factors of the threshold voltage is correlated with the P-type well concentration $N_a$, so that the threshold voltage can be always determined by the P-type well concentration $N_a$, thereby stabilizing the threshold voltage of the semiconductor device and reducing the complexity of design and manufacturing.

According to an embodiment of the disclosure, for each gate region, the thickness $T_{ox}$ of the gate oxide layer (121; 221; 321; 421; 521) in the second direction at any depth hx within the depth range from the third depth h3 to the second depth h2 and the P-type well concentration $N_a$ of the first P-type body layer (112; 212; 312; 412; 512) at the depth hx satisfies the following formula:

$$T_{ox} \leq \frac{V_{th\_1}\varepsilon_0\varepsilon_{ox}}{\sqrt{4\varepsilon_0\varepsilon_s KTN_a In\left(\frac{N_a}{N_i}\right)}}$$

Formula 1

where K is a Boltzmann constant, T is an absolute temperature, $N_i$ is a concentration of intrinsic carriers of the first P-type body layer at the depth hx, $\varepsilon_0$ is a vacuum permittivity, $\varepsilon_s$ is a relative permittivity of silicon, $\varepsilon_{ox}$ is a relative permittivity of the gate oxide layer, and $V_{th\_1}$ is a preset constant. For example, when the threshold voltage $V_{th}$ of the semiconductor device is 5V, $V_{th\_1}$ may be set to 4 V to 4.2 V. By means of the above design, while the thickness $T_{ox}$ of the gate oxide layer is determined by the P-type well concentration $N_a$, the influence of the change in thickness $T_{ox}$ of the oxide on the threshold voltage of the semiconductor device is less than the influence caused by the decrease in the P-type well concentration $N_a$.

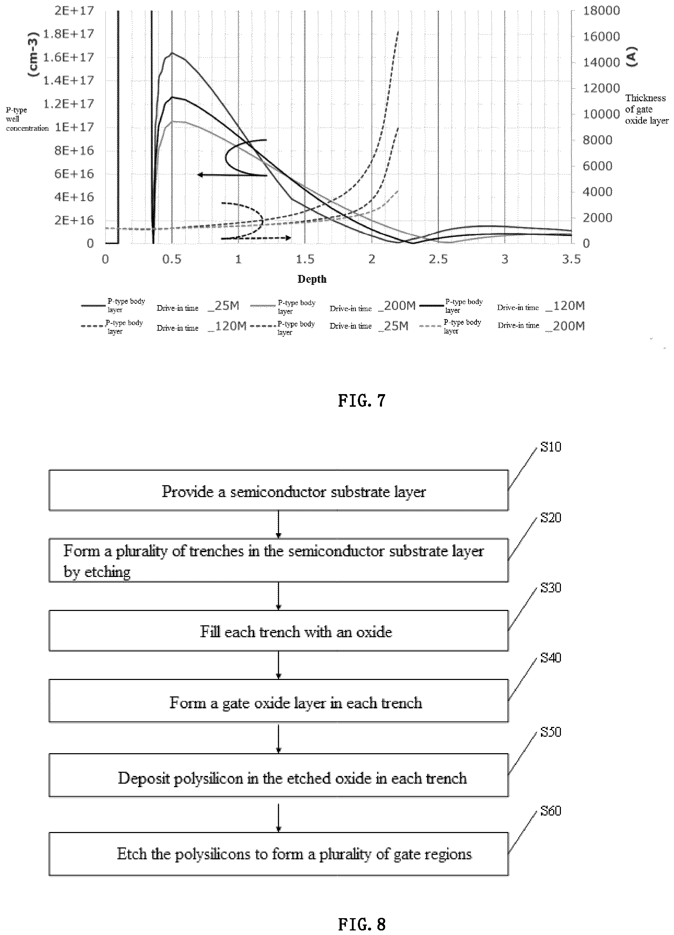

For example, FIG. 7 shows an example of a curve diagram of the relationship between the thickness $T_{ox}$ of the gate oxide layer and the P-type well concentration $N_a$ of the first P-type body layer of the semiconductor device according to an embodiment of the disclosure. FIG. 7 shows the variation values (the coordinate axis on the left and multiple solid curves) of the P-type well concentration $N_a$ of the first P-type body layer at different depths under different working conditions (the annealing temperature is 1150°C, and the annealing time is 25 minutes/120 minutes/200 minutes (25M/120M/200M)), and also shows the variation ranges (the coordinate axis on the right and multiple dashed curves) of the thickness $T_{ox}$ of the oxide calculated according to Formula 1 based on the P-type well concentration $N_a$ of the first P-type body layer under different working conditions described above. In this example, the depth of the trench where the gate oxide layer of the gate region is located is 1.8 $\mu$m to 2.0 $\mu$m. According to needs, the depth of the trench may be other values, which is not limited here. The P-type well concentration $N_a$ (solid lines) of the first P-type body layer continuously decreases after the depth 0.5 $\mu$m shown by the horizontal axis. Therefore, the thickness $T_{ox}$ of the gate oxide layer continuously increases to adapt to the variation of the P-type well concentration $N_a$, and is preferably not higher than the curve shown by the dashed line (obtained according to Formula 1).

Table 2

| Vth_1 | 4.18 V | 4.15 V | 4.12 V | 4.17 V |
|---|---|---|---|---|
| Thickness of gate oxide layer | 1200 A | 2050 A | 4700 A | 5800 A |
| Depth | 0.50 $\mu$m | 1.50 $\mu$m | 2 $\mu$m | 2.80 $\mu$m |
| P-type well concentration $N_a$ | 1.20E+17 | 4.00E+16 | 9.00E+15 | 1.27E+14 |

For example, Table 2 shows the values of the thickness $T_{ox}$ of the oxide varied depending on the P-type well concentration $N_a$ of the first P-type body layer based on Formula 1 at different depths when the constant $V_{th\_1}$ is set within the range of 4 V to 4.2 V.

According to the embodiments of the disclosure, as shown in FIG. 2, along the first direction D1, the second depth h2 may be within a range of a depth where the carrier storage layer 113 is located. In other words, the bottom 124 of the polysilicon 122 may be within the range of the depth where the carrier storage layer 113 is located.

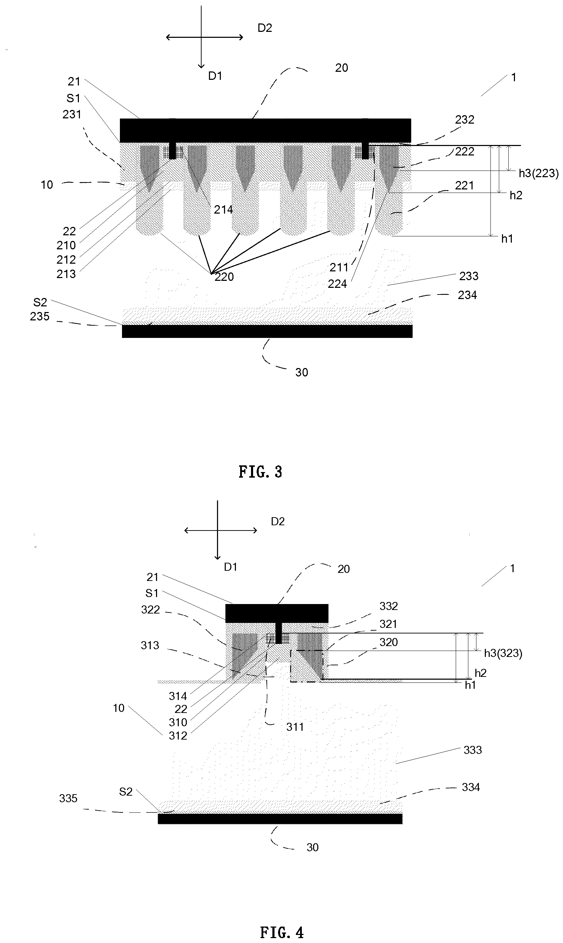

According to the embodiments of the disclosure, as shown in FIG. 3, along the first direction D1, the second depth h2 may exceed the range of the depth where the carrier storage layer 213 is located. In other words, the bottom 224 of the polysilicon 222 may exceed the range of the depth where the carrier storage layer 213 is located.

According to the embodiments of the disclosure, as shown in FIG. 2, FIG. 3 and FIG. 5, for each gate region (120; 220; 420), in the second direction D2, the part of the gate oxide layer (121; 221; 421) from the third depth h3 to the second depth h2 may have the gradually increasing thickness on both sides along the second direction D2. In other words, the thicknesses of both side walls of the gate oxide layer (121; 221; 421) respectively contacting two side surfaces of the polysilicon gradually increase. By means of the above design, the thickness of the gate oxide layer can increase smoothly, and it is also easy for the formation of the gate oxide layer.

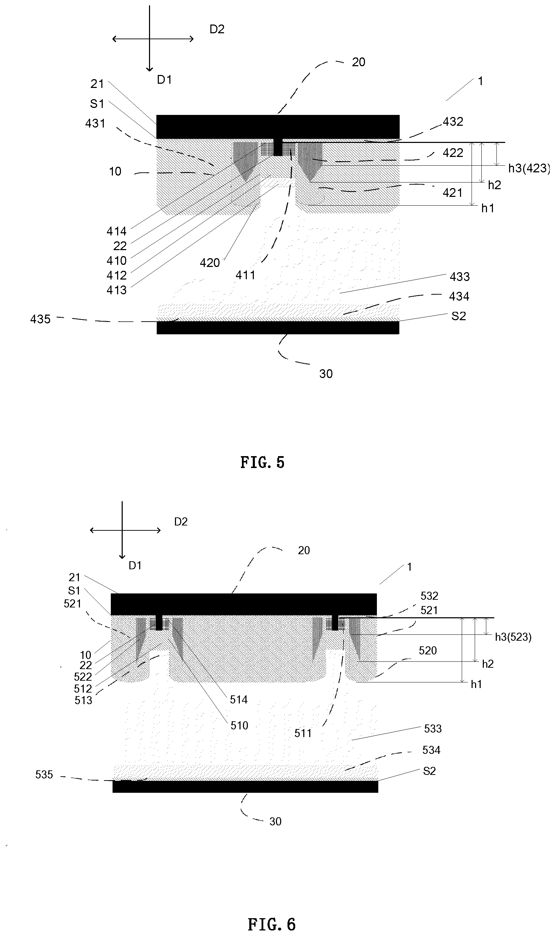

According to the embodiments of the disclosure, as shown in FIG. 4 and FIG. 6, for each gate region (320; 520), in the second direction D2, the part of the gate oxide layer (321; 521) from the third depth h3 to the second depth h2 may have the gradually increasing thickness only on a side close to the source region (310; 510).

According to the embodiments of the disclosure, as shown in FIG. 4, for each gate region 320, in the second direction D2, a side of a part of the gate oxide layer 321 from the first surface S1 to the third depth h3 away from the source region 310 is exposed to an outside of the semiconductor device along the second direction D2.

According to the embodiments of the disclosure, as shown in FIG. 2, FIG. 3 and FIG. 5, the semiconductor layer 10 may further include a second P-type body layer (131; 231; 431). The second P-type body layer (131; 231; 431) extends along the first direction D1 from the depth where the top (114; 214; 414) of the N-type source region (111; 211; 411) is located, and the second P-type body layer (131; 231; 431) contacts the gate oxide layer (121; 221; 421) of the adjacent gate region (120; 220; 420) along the second direction D2. In some embodiments, as shown in FIG. 5, the second P-type body layer 431 surrounds the bottom of the gate oxide layer 421 of the adjacent gate region 420.

According to the embodiments of the disclosure, as shown in FIG. 6, at least one gate region in the plurality of gate regions 520 may include one gate oxide layer 521 and two pieces of polysilicon 522. The two pieces of polysilicon 522 are arranged along the second direction D2 perpendicular to the first direction D1 in the gate oxide layer 521. It should be noted that the distance between the two pieces of polysilicon in one gate oxide layer meets the requirement of not interfering with each other.

According to the embodiments of the disclosure, the semiconductor device 1 may be a trench IGBT unit.

According to the embodiments of the disclosure, the N-type source region may be an N+ source region.

According to the embodiments of the disclosure, as shown in FIG. 2 to FIG. 6, the semiconductor layer 10 may further include an N-type drift layer 133, a buffer layer 134 and an emitter layer 135.

According to the embodiments of the disclosure, as shown in FIG. 2 to FIG. 6, the semiconductor layer 10 further includes an inter layer dielectric (ILD) (132; 432) extending along the first direction from the first surface. The inter layer dielectric may be an oxide layer. The inter layer dielectric (132; 432) contacts a top (114; 414) of the N-type source region (111; 411), and a top of the gate oxide layer (121; 421) and a top of the polysilicon (122; 422) in each gate region (120; 420) along the first direction D1.

According to the embodiments of the disclosure, as shown in FIG. 2 to FIG. 6, the semiconductor device further includes a top surface metal layer 20. The top surface metal layer 20 includes a first part 21 arranged on the inter layer dielectric 132 and a second part 22 extending from a bottom surface of the first part along the first direction through the inter layer dielectric 132 and the N-type source region 111 to contact the first P-type body layer 121.

According to the embodiments of the disclosure, as shown in FIG. 2 to FIG. 6, the semiconductor device 1 further includes a bottom surface metal layer 30. The bottom surface metal layer 30 is arranged to cover the second surface S2 of the semiconductor layer 10 along a direction opposite to the first direction D1.

According to the embodiments of the disclosure, a threshold voltage $V_{th}$ of the semiconductor device 1 is:

$$V_{th} = \theta_{ms} + \frac{2kT}{q} \cdot \ln\frac{N_a}{N_i} + V_{th-1} - \frac{Q_{fc} + Q_{ss} + Q_m}{C_{ox}}$$

## Formula 2

where $\theta_{ms}$ is a metal-semiconductor work function difference, k is a Boltzmann constant, T is an absolute temperature, q is a charge, $Q_m$ is a charge in an equivalent metal, $Q_{ss}$ is an equivalent surface state charge, $Q_{fc}$ is an equivalent fixed charge, and $C_{ox}$ is a capacitance of the oxide layer.

According to the embodiments of the disclosure, at least one gate region in the plurality of gate regions may be only adjacent to the second P-type body layer but not adjacent to the N-type source region. In other words, the gate oxide layer of the at least one gate region contacts the adjacent second P-type body layer along the second direction.

In some embodiments, gate regions adjacent to the N-type source region in the plurality of gate regions are active gate regions, and gate regions adjacent to the second P-type body layer but not adjacent to the N-type source region in the plurality of gate regions are passive gate regions. The passive gate regions and the active gate regions are arranged in a preset number proportion in the semiconductor device so as to obtain better didt and dvdt control abilities at switching transients. As shown in FIG. 2 and FIG. 3, the number proportion of the passive gate regions to the active gate regions may be 1:2. It should be noted that the lower the proportion of the number of the active gate regions to the number of all the gate regions, the higher the didt and dvdt of the semiconductor device; and the higher the proportion, the lower the didt and dvdt of the semiconductor device. In some embodiments, the passive gate regions may be called dummy gate regions. In some embodiments, the passive gate regions may be called grounded gate regions.

The embodiments of the disclosure will be described in detail below.

First embodiment

FIG. 2 shows a semiconductor device 1 according to the first embodiment of the disclosure. The semiconductor device 1 is a trench IGBT unit. As shown in FIG. 2, the semiconductor device 1 includes a semiconductor layer 10, a top surface metal layer 20 and a bottom surface metal layer 30.

The semiconductor layer 10 has a first surface S1 and a second surface S2 opposite to each other. The semiconductor layer 10 includes two source regions 110, six gate regions 120, three second P-type body layers 131, an inter layer dielectric 132, an N-type drift layer 133, a buffer layer 134 and an emitter layer 135.

Each source region 110 includes an N-type source region 111, a first P-type body layer 112 and a carrier storage layer 113 stacked along a first direction D1 pointing from the first surface S1 to the second surface S2. The N-type source region is an N+ source region.

The six gate regions 120 are arranged along a second direction D2 perpendicular to the first direction D1. Each gate region 120 includes a gate oxide layer 121 and polysilicon 122. A side wall and a bottom 124 of the polysilicon 122 are surrounded by the gate oxide layer 121.

Each source region 110 is arranged between the adjacent two of the six gate regions 120 in the second direction D2, and contacts the gate oxide layers 121, 221 of the adjacent two gate regions along the second direction D2.

In each gate region 120, with respect to the first surface S1, the gate oxide layer 121 extends along the first direction D1 from a depth where a top 114 of the N-type source region 111 is located to a first depth h1. The bottom 124 of the polysilicon is away from the first surface S1 and is located at a second depth h2 with respect to the first surface S1. A part of the gate oxide layer 121 from a top of the gate oxide layer to the third depth h3 has a constant thickness in the second direction. Third depth h3<second depth h2<first depth h1. A part of the gate oxide layer 121 from the third depth h3 to the second depth h2 has a gradually increasing thickness in the second direction D2. The third depth h3 is within a range of a depth where the first P-type body layer 112 is located. Along the first direction D1, the second depth h2 may be within a range of a depth where the carrier storage layer 113 is located.

For each gate region 120, the thickness of the gate oxide layer 121 in the second direction D2 at any depth hx within the depth range from the third depth h3 to the second depth h2 and the P-type well concentration $N_a$ of the first P-type body layer 112 at the depth hx may satisfy Formula 1.

For each gate region 120, in the second direction D2, the part of the gate oxide layer 121 from the third depth h3 to the second depth h2 has the gradually increasing thickness on both sides along the second direction D2.

The second P-type body layer 131 extends along the first direction D1 from the depth where the top 114 of the N-type source region 111 is located, and the second P-type body layer 131 contacts the gate oxide layer 121 of the adjacent gate region 120 along the second direction D2.

In the six gate regions 120 arranged along the second direction D2, gate regions 120 (i.e., the first, second, fifth and sixth gate regions from the left in FIG. 2) adjacent to the N-type source region 111 are active gate regions, and gate regions 120 (i.e., the third and fourth gate regions from the left) adjacent to the second P-type body layer 131 but not adjacent to the N-type source region 111 are passive gate regions. The passive gate regions and the active gate regions are arranged in a preset number proportion of 1:2 in the semiconductor device 1.

The inter layer dielectric 132 extends along the first direction from the first surface. The inter layer dielectric is an oxide layer. The inter layer dielectric 132 contacts a top 114 of the N-type source region 111, and a top of the gate oxide layer 121 and a top of the polysilicon 122 in each gate region 120 along the first direction D1.

The top surface metal layer 20 includes a first part 21 arranged on the inter layer dielectric 132 and a second part 22 extending from a bottom surface of the first part along the first direction through the inter layer dielectric 132 and the N-type source region 111 to contact the first P-type body layer 121.

The bottom surface metal layer 30 is arranged to cover the second surface S2 of the semiconductor layer 10 along a direction opposite to the first direction D1.

The first embodiment of the disclosure has been described above in conjunction with the accompanying drawings. In the following description of other embodiments, components corresponding to or having the same function as those in the first embodiment will be denoted by the same or similar reference numerals, and descriptions of some components, operations and effects may be omitted to avoid repetition.

Second embodiment

FIG. 3 shows a semiconductor device 1 according to the second embodiment of the disclosure. The semiconductor device 1 of the second embodiment is different from the first embodiment in that along the first direction D1, the second depth h2 exceeds the range of the depth where the carrier storage layer 213 is located (closer to the second surface S2).

Third embodiment

FIG. 4 shows a semiconductor device 1 according to the third embodiment of the disclosure. The semiconductor layer of the semiconductor device 1 has one source region 310 and two gate regions 320. For each gate region 320, in the second direction D2, the part of the gate oxide layer 321 from the third depth h3 to the second depth h2 may have the gradually increasing thickness only on a side close to the source region 310 and have a basically constant thickness on the other side.

In addition, for each gate region 320, in the second direction D2, a side of a part of the gate oxide layer 321 from the first surface S1 to the third depth h3 away from the source region 310 is exposed to an outside of the semiconductor device along the second direction D2.

As shown in FIG. 4, the semiconductor device 1 of the third embodiment does not include the second P-type body layer, and the two gate regions 320 are both active gate regions.

Fourth embodiment

FIG. 5 shows a semiconductor device 1 according to the fourth embodiment of the disclosure. The semiconductor device 1 of the fourth embodiment is different from the first embodiment in that the second P-type body layer 431 surrounds the bottom of the gate oxide layer 421 of the adjacent gate region 420.

Fifth embodiment

FIG. 6 shows a semiconductor device 1 according to the fifth embodiment of the disclosure. The semiconductor device 1 of the fifth embodiment is different from the first embodiment in that for each gate region 520, in the second direction D2, the part of the gate oxide layer 521 from the third depth h3 to the second depth h2 has the gradually increasing thickness only on a side close to the source region 510.

At least one gate region (the gate region in the middle in FIG. 6) in the plurality of gate regions 520 includes one gate oxide layer 521 and two pieces of polysilicon 522. The two pieces of polysilicon 522 are arranged along the second direction D2 perpendicular to the first direction D1 in the gate oxide layer 521.

Method for manufacturing semiconductor device

An embodiment of the disclosure further provides a method for manufacturing the semiconductor device described above. Referring to FIG. 8, the method includes the following steps S10 to S60.

Step S10: Provide a semiconductor substrate layer.

A material of the semiconductor substrate layer may be an N-type semiconductor material or a P-type semiconductor material. The main doping types of the N-type and P-type semiconductor materials may be phosphorus (Group V) and boron (Group III).

Step S20: Form a plurality of trenches in the semiconductor substrate layer by etching.

A bottom of the trench will correspond to a bottom of the gate oxide layer, so each trench is etched along a first direction to a position corresponding to a first depth h1.

Here, chemical vapor deposition (CVD) may be used to deposit an oxide layer on the surface of the semiconductor layer as a mask layer used during the trench etching. As an alternative, a photoresist may be used as a mask layer during the trench etching.

Step S30: Fill each trench with an oxide.

Here, the oxide may be silicon dioxide ($SiO_2$), silicon oxynitride (SiON), silicon oxycarbonitride (SiOCN), etc.

Step S40: Form a gate oxide layer in each trench.

The gate oxide layer may be formed by etching, etching+oxide addition, etc. The formed gate oxide layer has the shape and properties as disclosed in the above embodiments.

Step S50: Deposit polysilicon in the etched oxide in each trench.

Step S60: Etch the polysilicon to form a plurality of gate regions.

Optionally, during the polysilicon etching, the adjacent gate oxide layer (or other oxides) may be etched together such that the tops of the polysilicon and the gate oxide layer are flush.

In some embodiments, the forming the gate oxide layer in each trench in step S40 includes: etching the oxide to a position corresponding to a third depth h3, and etching the oxide from the third depth h3 to a position corresponding to a second depth h2. In some embodiments, isotropic dry etching is performed on the oxide to the position corresponding to the third depth h3. In some embodiments, anisotropic dry etching is performed on the oxide from the third depth h3 to the position corresponding to the second depth h2.

In some embodiments, the filling each trench with the oxide in step S30 includes: etching the oxide while filling each trench with the oxide to form a notch (e.g., a notch with a triangular longitudinal section) on the oxide. In some embodiments, the oxide is etched with an etching gas containing carbon or fluorine (C/F). In some embodiments, the trench is filled with the oxide by depositing $SiH_4+N_2O/O_2$ or $TEOS[Si(OC_2H_5)_4]+O_2/O_3$. In some embodiments, a depth-width ratio of the notch (especially the triangular notch) may be adjusted by adjusting the ratio of C/F contained in the depositing gas and the etching gas.

In some embodiments, the forming the gate oxide layer in each trench in step S40 includes: performing isotropic dry etching on the oxide with the notch to form the gate oxide layer.

In some embodiments, the forming the gate oxide layer in each trench in step S40 includes: etching the oxide to the position corresponding to the second depth h2, and filling each trench with the oxide from the second depth h2 while reserving a required space for the polysilicon to the position corresponding to the third depth h3.

In some embodiments, the forming the gate oxide layer in each trench in step S40 further includes: filling each trench with an additional oxide to form a side wall of the gate oxide layer after the oxide is etched from the third depth h3 to the position corresponding to the second depth h2.

In some embodiments, the method further includes: forming a source region in the semiconductor substrate layer.

It should be noted that the step of forming the source region in the semiconductor substrate layer may be implemented between any steps after step S10, or may be divided into several substeps which are implemented between different sets of steps.

In some embodiments, the step of forming the source region in the semiconductor substrate layer includes: after etching the polysilicon to form the plurality of gate regions in step S60, sequentially forming the first P-type body layer and a carrier storage layer by ion implantation and drive-in from a side of the first surface of the semiconductor substrate layer; and forming an N-type source region in the first P-type body layer along a direction opposite to the first direction.

In some embodiments, the step of forming the source region in the semiconductor substrate layer includes: before forming the plurality of trenches in the semiconductor substrate layer in step S20, forming the carrier storage layer on the semiconductor substrate layer.

In some embodiments, the method further includes: forming an inter layer dielectric covering the plurality of gate regions and the source region by depositing an oxide, a top surface of the inter layer dielectric being the first surface of the semiconductor layer.

In some embodiments, the method further includes:

forming a contact hole at a position corresponding to the source region, the contact hole extending from the top surface of the inter layer dielectric along the first direction through the inter layer dielectric and the N-type source region to the first P-type body layer;
forming a top surface metal layer on the top surface of the inter layer dielectric and in the contact hole; and
forming a bottom surface metal layer on a side of a second surface of the semiconductor substrate layer.

The method embodiment of the disclosure will be described in detail below.

Sixth embodiment

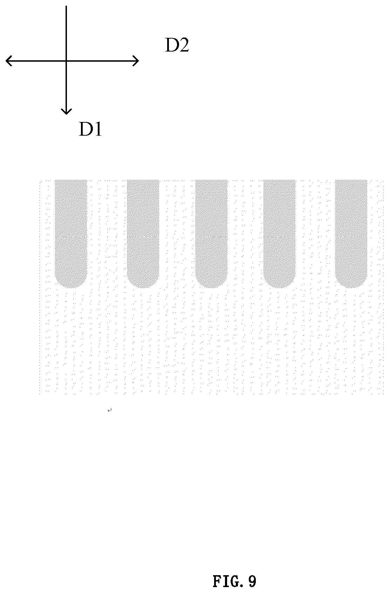

FIG. 9 to FIG. 18 are specific steps of the sixth embodiment.

A semiconductor substrate layer is provided.

A carrier storage layer is formed on the semiconductor substrate layer. It should be noted that the carrier storage layer is not shown in the drawings for the sake of brevity.

A plurality of trenches are formed in the semiconductor substrate layer by etching such that each trench is configured to extend from a side of a first surface of the semiconductor substrate layer along a first direction D1 to a position corresponding to a first depth h1. The structure after this step is shown in FIG. 9.

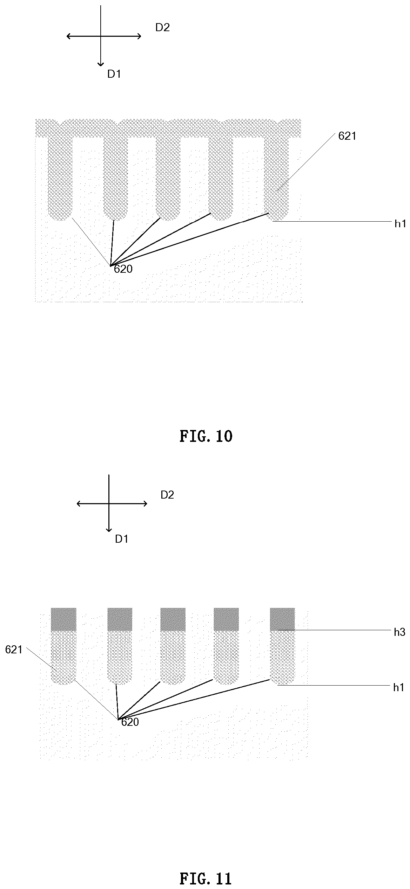

Each trench is filled with an oxide. The structure after this step is shown in FIG. 10.

A gate oxide layer 621 is formed in each trench, which includes the following steps:

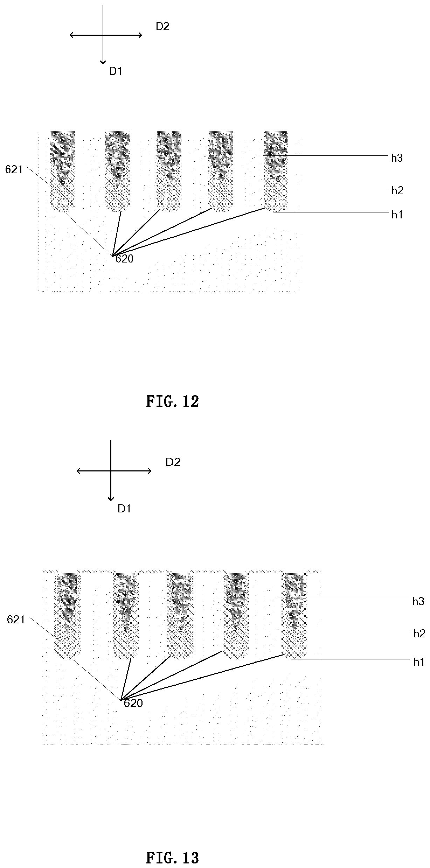

- Isotropic dry etching is performed on the oxide to a position corresponding to a third depth h3. The structure after this step is shown in FIG. 11.
- Anisotropic dry etching is performed on the oxide from the third depth h3 to a position corresponding to a second depth h2. The structure after this step is shown in FIG. 12.
- Each trench is filled with an additional oxide to form a side wall of the gate oxide layer 621 after the oxide is etched from the third depth h3 to the position corresponding to the second depth h2. The structure after this step is shown in FIG. 13.

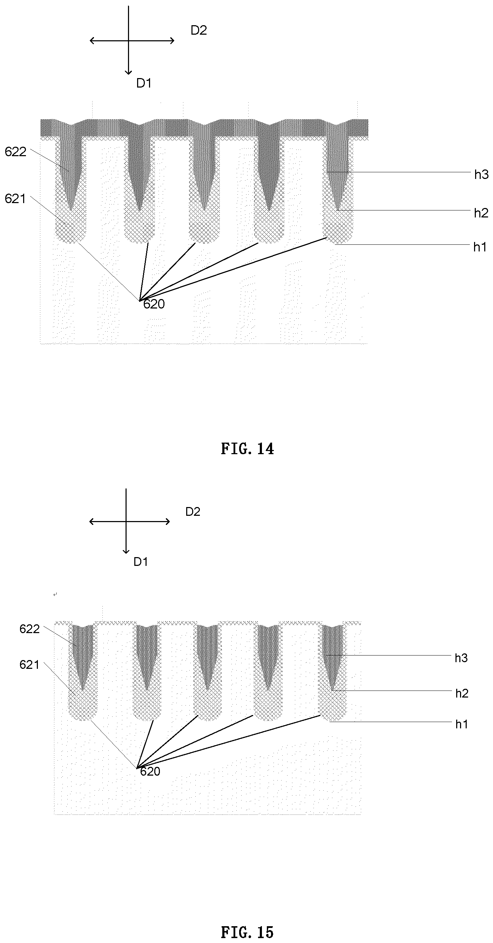

Polysilicon 622 is deposited in the etched oxide in each trench. The structure after this step is shown in FIG. 14.

The polysilicon 622 is etched to form a plurality of gate regions 620. The structure after this step is shown in FIG. 15.

A source region 610 is formed in the semiconductor substrate layer, which includes the following steps:

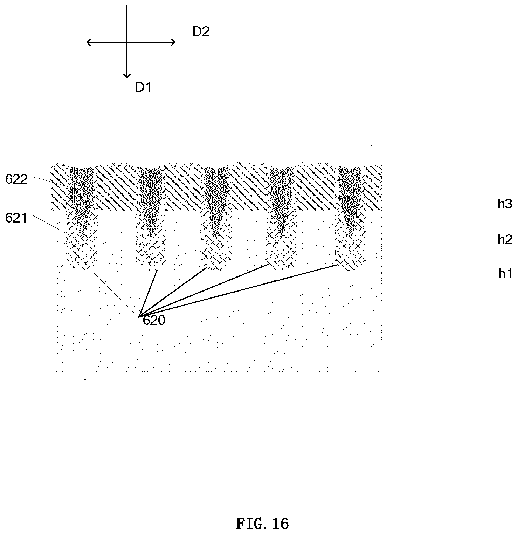

- A first P-type body layer 612 and a second P-type body layer 631 are sequentially formed by ion implantation and drive-in from the side of the first surface of the semiconductor substrate layer. The structure after this step is shown in FIG. 16.

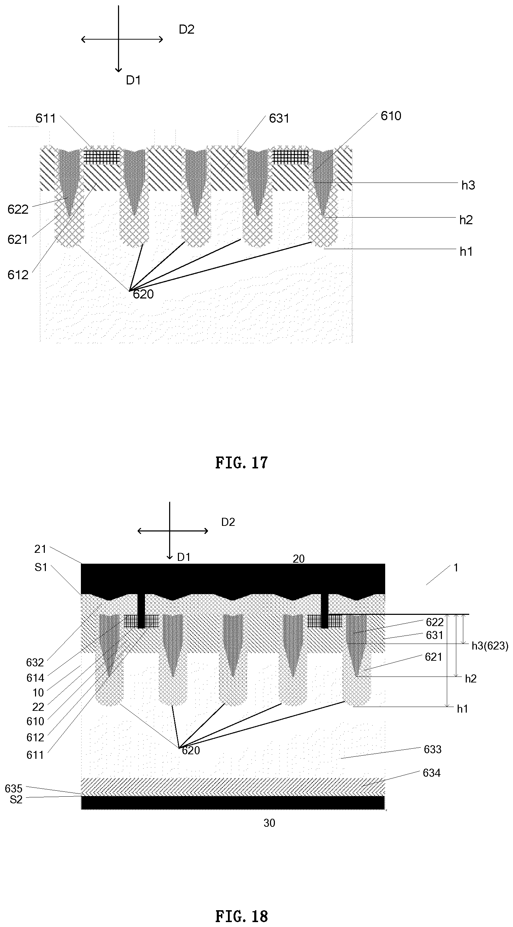

- An N-type source region 611 is formed in the first P-type body layer 612 along a direction opposite to the first direction D1. The structure after this step is shown in FIG. 17.

An inter layer dielectric 632 covering the plurality of gate regions 620 and the source region 610 are formed by depositing an oxide. A top surface of the inter layer dielectric 632 is the first surface S1 of the semiconductor layer.

A buffer layer 634 and a P-type emitter layer 635 are formed along the first direction D1 on a side of the semiconductor substrate layer away from the first surface of the trench. A bottom surface of the P-type emitter layer 635 is a second surface S2 of the semiconductor layer.

A contact hole is formed at a position corresponding to the source region. The contact hole extends from the top surface of the inter layer dielectric 632 along the first direction D1 through the inter layer dielectric 632 and the N-type source region 611 to the first P-type body layer 612.

A top surface metal layer 20 is formed on the top surface of the inter layer dielectric 632 and in the contact hole.

A bottom surface metal layer 30 is formed on a side of the second surface of the semiconductor substrate layer. The structure after this step is shown in FIG. 18.

Although the preferred embodiments of the disclosure have been described in detail above, the disclosure is not limited thereto, and those skilled in the art can make various modifications and variations to the embodiments within the scope of the disclosure.

For example, at least one gate region (the 3rd and 4th gate regions from the left in FIG. 2) in the plurality of gate regions 120 may be only adjacent to the second P-type body layer but not adjacent to the N-type source region. The at least one gate region is a dummy gate region. The dummy gate regions may be provided in proportion to the gate regions of the adjacent source region.

Although the inventive subject matter has been disclosed in the context of certain preferred or illustrated embodiments and examples, those skilled in the art will understand that the subject matter of the disclosure extends beyond the specifically disclosed embodiments to other optional embodiments and/or uses of the disclosure as well as apparent modifications and equivalents of the disclosure. In addition, although several variations of the disclosed embodiments have been shown and described in detail, other modifications within the scope of the subject matter of the disclosure based on the disclosure will be apparent to those skilled in the art. It is also to be expected that various combinations or sub-combinations of specific features and aspects of the disclosed embodiments can be made and these combinations or sub-combinations shall still fall within the scope of the subject matter of the disclosure. Accordingly, it should be understood that various features and aspects of the disclosed embodiments can be combined with or substituted for each other to form different modes of the disclosed inventive subject matter. Therefore, the scope of the inventive subject matter disclosed herein is not intended to be limited by the above specifically disclosed embodiments, but should be determined only by reading the claims fairly.

**Claims**

1. A semiconductor device, comprising:
   a semiconductor layer, having a first surface and a second surface opposite to each other, the semiconductor layer comprising:

   a source region, comprising an N-type source region, a first P-type body layer and a carrier storage layer stacked along a first direction pointing from the first surface to the second surface; and
   a plurality of gate regions, arranged along a second direction perpendicular to the first direction, each gate region comprising a gate oxide layer and polysilicon, and a side wall and a bottom of the polysilicon being surrounded by the gate oxide layer,
   wherein the source region is arranged between the adjacent two of the plurality of gate regions in the second direction, and contacts the gate oxide layers of the adjacent two gate regions along the second direction;
   wherein in each gate region,

   with respect to the first surface, the gate oxide layer extends along the first direction from a depth where a top of the N-type source region is located to a first depth $h1$;
   the bottom of the polysilicon is away from the first surface and is located at a second depth $h2$ with respect to the first surface;
   a part of the gate oxide layer from a top of the gate oxide layer to a third depth $h3$ has a constant thickness in the second direction, wherein $h3<h2<h1$;
   a part of the gate oxide layer from the third depth $h3$ to the second depth $h2$ has a gradually increasing thickness in the second direction; and

the third depth h3 is within a range of a depth where the first P-type body layer is located.

2. The semiconductor device according to claim 1, wherein for each gate region, a thickness of the gate oxide layer in the second direction at any depth hx within a depth range from the third depth h3 to the second depth h2 is a function of a P-type well concentration $N_a$ of the first P-type body layer at the depth hx.

3. The semiconductor device according to claim 2, wherein for each gate region, the thickness $T_{ox}$ of the gate oxide layer in the second direction at any depth hx within the depth range from the third depth h3 to the second depth h2 and the P-type well concentration $N_a$ of the first P-type body layer at the depth hx satisfies the following formula:

$$T_{ox} \leq \frac{V_{th\_1}\varepsilon_0\varepsilon_{ox}}{\sqrt{4\varepsilon_0\varepsilon_s KTN_a In\left(\frac{N_a}{N_i}\right)}}$$

wherein K is a Boltzmann constant, T is an absolute temperature, $N_i$ is a concentration of intrinsic carriers of the first P-type body layer at the depth hx, $\varepsilon_0$ is a vacuum permittivity, $\varepsilon_s$ is a relative permittivity of silicon, $\varepsilon_{ox}$ is a relative permittivity of the gate oxide layer, and $V_{th\_1}$ is a preset constant.

4. The semiconductor device according to claim 1, wherein

along the first direction, the second depth h2 is within a range of a depth where the carrier storage layer is located; or
along the first direction, the second depth h2 exceeds the range of the depth where the carrier storage layer is located.

5. The semiconductor device according to claim 1, wherein for each gate region, in the second direction, the part of the gate oxide layer from the third depth h3 to the second depth h2 has the gradually increasing thickness on both sides along the second direction.

6. The semiconductor device according to claim 1, wherein for each gate region, in the second direction, the part of the gate oxide layer from the third depth h3 to the second depth h2 has the gradually increasing thickness only on a side close to the source region.

7. The semiconductor device according to claim 6, wherein for each gate region, in the second direction, a side of a part of the gate oxide layer from the first surface to the third depth h3 away from the source region is exposed to an outside of the semiconductor device along the second direction.

8. The semiconductor device according to claim 1, wherein the semiconductor layer further comprises a second P-type body layer, the second P-type body layer extending along the first direction from the depth where the top of the N-type source region is located, and the second P-type body layer contacting the gate oxide layer of the adjacent gate region along the second direction.

9. The semiconductor device according to claim 8, wherein gate regions adjacent to the N-type source region in the plurality of gate regions are active gate regions, and gate regions adjacent to the second P-type body layer but not adjacent to the N-type source region in the plurality of gate regions are passive gate regions, the passive gate regions and the active gate regions being arranged in a preset number proportion in the semiconductor device.

10. The semiconductor device according to claim 1, wherein at least one gate region in the plurality of gate regions comprises one gate oxide layer and two pieces of polysilicon, the two pieces of polysilicon being arranged along the second direction in the gate oxide layer.

11. The semiconductor device according to any one of claims 1 to 10, wherein the semiconductor device is a trench IGBT unit.

12. A method for manufacturing the semiconductor device according to any one of claims 1 to 11, comprising:

providing a semiconductor substrate layer;
forming a plurality of trenches in the semiconductor substrate layer by etching such that each trench is configured to extend from a side of a first surface of the semiconductor substrate layer along a first direction to a position corresponding to the first depth h1;
filling each trench with an oxide;
forming a gate oxide layer in each trench;
depositing polysilicon in the etched oxide in each trench; and
etching the polysilicon to form a plurality of gate regions.

13. The method according to claim 12, wherein the forming the gate oxide layer in each trench comprises:

performing isotropic dry etching on the oxide to a position corresponding to the third depth h3, and
performing anisotropic dry etching on the oxide from the third depth h3 to a position corresponding to the second depth h2.

14. The method according to claim 13, wherein the forming the gate oxide layer in each trench further comprises:
filling each trench with an additional oxide to form a side wall of the gate oxide layer after the oxide is etched from the third depth h3 to the position corresponding to the second depth h2.

15. The method according to claim 12, further comprising:
forming a source region in the semiconductor substrate layer.

16. The method according to claim 15, wherein the forming the source region in the semiconductor substrate layer comprises:

sequentially forming the first P-type body layer and the carrier storage layer by ion implantation and drive-in from the side of the first surface of the semiconductor substrate layer; and
forming an N-type source region in the first P-type body layer along a direction opposite to the first direction.

17. The method according to claim 15 or 16, further comprising:
forming an inter layer dielectric covering the plurality of gate regions and the source region by depositing an oxide, a top surface of the inter layer dielectric being the first surface of the semiconductor layer.

18. The method according to claim 17, further comprising:

forming a contact hole at a position corresponding to the source region, the contact hole extending from the top surface of the inter layer dielectric along the first direction through the inter layer dielectric and the N-type source region to the first P-type body layer;
forming a top surface metal layer on the top surface of the inter layer dielectric and in the contact hole; and
forming a bottom surface metal layer on a side of a second surface of the semiconductor substrate layer.

FIG. 1

FIG. 2

FIG. 3

FIG. 4

D2

D1

20

21
S1
431

1

432

422

h3(423)

10

h2

421

h1

414
22
410
412
413

420

411

433

434

435

S2

30

**FIG. 5**

D2

D1

20

21
S1
521

1

532
521

h3(523)

10
22
522
512
513

520

h2

514

h1

510

511

533

534

535

S2

30

**FIG. 6**

FIG. 7

FIG. 8

FIG. 9

D2

D1

621

h1

620

FIG. 10

D2

D1

h3

621

h1

620

FIG. 11

FIG. 12

FIG. 13

FIG. 14

FIG. 15

FIG. 16

**FIG. 17**

**FIG. 18**

Europäisches
Patentamt

European
Patent Office

Office européen
des brevets

# EUROPEAN SEARCH REPORT

Application Number

EP 24 20 9923

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2012 138567 A (DENSO CORP) 19 July 2012 (2012-07-19) | 1,2,4,5, 8-11 | INV. H10D12/01 |
| Y | * Figure 22 and the correlated text * | 12,15-18 | H10D12/00 |
| A | * abstract * * paragraph [0089] * | 3,6,7, 13,14 | H10D64/27 |
| Y | EP 4 120 360 A1 (HITACHI ENERGY SWITZERLAND AG [CH]) 18 January 2023 (2023-01-18) | 1-12, 15-18 | |
| A | * Figure 15 and the correlated text * * paragraphs [0021], [0041], [0045], [0097] * * paragraph [0062] - paragraph [0066] * | 13,14 | |
| Y | US 2015/346270 A1 (ZUNDEL MARKUS [DE] ET AL) 3 December 2015 (2015-12-03) | 1-5, 10-12 | |
| A | * Figure 1C and the correlated text * * paragraph [0040] * | 6-9, 13-18 | |
| Y | US 2002/153558 A1 (TAKEMORI TOSHIYUKI [JP] ET AL) 24 October 2002 (2002-10-24) | 1-5, 10-12, 15-18 | |
| A | * Figures 27 - 48, 50 and the correlated passages * * paragraph [0131] * | 6-9,13, 14 | TECHNICAL FIELDS SEARCHED (IPC) H10D |
| Y | CN 109 256 417 A (FUJI ELECTRIC CO LTD) 22 January 2019 (2019-01-22) | 1-4,6-12 | |
| A | * Figures 1a - 1b and the correlated passages * | 5,13-18 | |
| A | JP 2012 216675 A (TOYOTA MOTOR CORP; DENSO CORP; TOYOTA CENTRAL RES & DEV) 8 November 2012 (2012-11-08) * the whole document * | 1-18 | |
| A | US 2015/108568 A1 (TERRILL KYLE [US] ET AL) 23 April 2015 (2015-04-23) * figure 1 * | 1-18 | |

The present search report has been drawn up for all claims

| Place of search | Date of completion of the search | Examiner |
|---|---|---|
| Munich | 21 February 2025 | Kostrzewa, Marek |

EPO FORM 1503 03.82 (P04C01)

**ANNEX TO THE EUROPEAN SEARCH REPORT
ON EUROPEAN PATENT APPLICATION NO.**

EP 24 20 9923

This annex lists the patent family members relating to the patent documents cited in the above-mentioned European search report.
The members are as contained in the European Patent Office EDP file on
The European Patent Office is in no way liable for these particulars which are merely given for the purpose of information.

21-02-2025

| Patent document cited in search report | | | Publication date | Patent family member(s) | | Publication date |
|---|---|---|---|---|---|---|
| JP 2012138567 | A | | 19-07-2012 | JP | 5594276 B2 | 24-09-2014 |
| | | | | JP | 2012138567 A | 19-07-2012 |
| | | | | US | 2012146091 A1 | 14-06-2012 |
| EP 4120360 | A1 | | 18-01-2023 | CN | 117652033 A | 05-03-2024 |
| | | | | DE | 212022000251 U1 | 15-04-2024 |
| | | | | EP | 4120360 A1 | 18-01-2023 |
| | | | | JP | 2024525835 A | 12-07-2024 |
| | | | | WO | 2023285550 A1 | 19-01-2023 |
| US 2015346270 | A1 | | 03-12-2015 | DE | 102013111154 A1 | 27-02-2014 |
| | | | | US | 2014097863 A1 | 10-04-2014 |
| | | | | US | 2015346270 A1 | 03-12-2015 |
| US 2002153558 | A1 | | 24-10-2002 | EP | 1248300 A2 | 09-10-2002 |
| | | | | JP | 4073176 B2 | 09-04-2008 |
| | | | | JP | 2002299619 A | 11-10-2002 |
| | | | | US | 2002153558 A1 | 24-10-2002 |
| | | | | US | 2005017294 A1 | 27-01-2005 |
| CN 109256417 | A | | 22-01-2019 | CN | 109256417 A | 22-01-2019 |
| | | | | US | 2019019861 A1 | 17-01-2019 |
| JP 2012216675 | A | | 08-11-2012 | JP | 5637916 B2 | 10-12-2014 |
| | | | | JP | 2012216675 A | 08-11-2012 |
| US 2015108568 | A1 | | 23-04-2015 | CN | 105723516 A | 29-06-2016 |
| | | | | EP | 3061135 A1 | 31-08-2016 |
| | | | | JP | 2016537809 A | 01-12-2016 |
| | | | | KR | 20160073379 A | 24-06-2016 |
| | | | | US | 2015108568 A1 | 23-04-2015 |
| | | | | WO | 2015060947 A1 | 30-04-2015 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 9000514 B2